(19) **Europäisches Patentamt / European Patent Office / Office européen des brevets**

(11) **EP 1 811 676 B1**

(12) **EUROPEAN PATENT SPECIFICATION**

(45) Date of publication and mention
of the grant of the patent:
**08.02.2012 Bulletin 2012/06**

(51) Int Cl.:
*H04B 1/10* (2006.01)    *H03D 3/00* (2006.01)

(21) Application number: **05805347.1**

(86) International application number:
**PCT/JP2005/019919**

(22) Date of filing: **28.10.2005**

(87) International publication number:
**WO 2006/049103 (11.05.2006 Gazette 2006/19)**

(54) **FM RECEIVER**

FM-EMPFÄNGER

RÉCEPTEUR FM

(84) Designated Contracting States:
**DE**

(30) Priority: **05.11.2004 JP 2004321509**

(43) Date of publication of application:
**25.07.2007 Bulletin 2007/30**

(73) Proprietor: **Pioneer Corporation
Kanagawa 212-0031 (JP)**

(72) Inventors:
• **ONO, Yasushi,
c/o Kawagoe Koujou
Kawagoe-shi,
Saitama 350-8555 (JP)**
• **OHASHI, Toru,
c/o Kawagoe Koujou
Kawagoe-shi,
Saitama 350-8555 (JP)**

• **AKIYAMA, Kiichiro,
c/o Kawagoe Koujou
Kawagoe-shi,
Saitama 350-8555 (JP)**
• **YAMAMOTO, Yuji,
c/o Kawagoe Koujou
Kawagoe-shi,
Saitama 350-8555 (JP)**

(74) Representative: **Sajda, Wolf E. et al
Meissner, Bolte & Partner GbR
Postfach 86 06 24
81633 München (DE)**

(56) References cited:
**EP-A- 0 940 909    GB-A- 2 113 930
JP-A- 3 004 624    JP-A- 3 034 728
JP-A- 6 216 651    US-A- 4 560 941**

**Description**

Technical Field

The present invention relates to an FM receiver using an arctangent detection method. A conventional FM receiver is known from EP-A-0 940 909.

Background Technique

As an FM receiver which receives FM broadcast, there have been known a quadrature detection receiver which performs FM detection using a quadrature detector, and an arctangent detection receiver which performs FM detection using an arctangent detector.

A quadrature detector and an arctangent detector are the same as each other in that they all apply a phase-detection to a frequency change of an FM wave. On the other hand, a quadrature detector is mainly used in an FM receiver which performs an FM detection by an analog signal processing, while an arctangent detector is mainly adopted in an FM receiver which performs an FM detection by a digital signal processing.

Namely, with a development in digitization of ground broadcasting or the like which is possible to improve a reception quality in a mobile reception that has attracted attention in recent years, there has been existing a problem that a signal distortion is likely to occur in a quadrature detector once an analogue-received FM wave is FM-detected through a digital signal processing. For this reason, an FM receiver which performs an FM detection through a digital signal processing has been mainly adopting an arctangent detector.

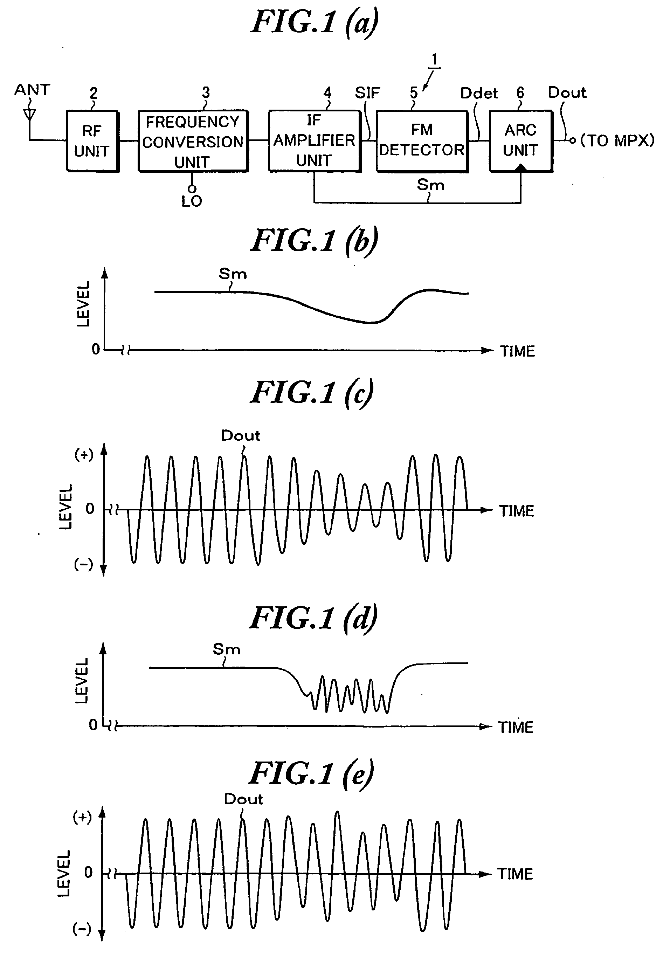

Fig. 1(a) is a block diagram showing a general construction of an FM receiver which employs a conventional arctangent detection method that takes into account a mobile reception.

As shown, the FM receiver 1 amplifies in its RF unit 2 (a high frequency amplifying unit) a broadcast wave received by a reception antenna ANT, and performs a frequency conversion by mixing together an amplified high frequency reception signal and a local oscillation signal having a turning frequency, thereby generating an intermediate frequency signal. The FM receiver 1 further applies a band limitation or the like to the intermediate frequency signal in its IF amplifier unit 4 and supplies the signal to an arctangent detector 5.

The arctangent detector 5 is formed of one shown in Fig. 1 of EP-A-0 940 909 (which is referred to as digital FM detector circuit in the patent gazette). In order to FM-detect an analog output signal SIF of the IF amplifier unit 4 (i.e., a band-limited intermediate frequency signal) using a digital signal processing, the arctangent detector 5 uses a predetermined sampling frequency to sample and input the analog output signal SIF, performs an orthogonal transformation to generate two signals S and C having a phase difference.
Then, a computation processing represented by the following equation (1) is performed in accordance with the two signals S and C, thereby detecting as a phase change $\omega t$ a frequency change of the above band-limited intermediate frequency signal, thus generating an FM detection signal Ddet, i.e. a demodulation signal whose level changes in response to a detected phase change.

Equation 1:

$$\Omega t = \arctan(S/C) \qquad \ldots (1).$$

Furthermore, in a mobile reception during which a reception environment changes at any moment in response to a movement, it is extremely important to reduce a noise feeling by improving an value or the like. For this reason, an FM detection signal Dout is processed in automatic reception means, which are also referred to, in an abbreviated form, as an ARC unit 6 having an ARC function (automatic reception function), while a processed FM detection signal Dout is supplied to an FM stereo demodulator (MPX) or the like.

Namely, the ARC unit 6 has a high cut control function which automatically inhibits a high frequency component of an FM detection signal Ddet in response to a level change of a signal Sm (hereinafter referred to as "S-meter signal") indicating a field intensity detected by the IF amplifier unit 4, and a channel separation control function which performs an automatic switchover between a monophonic playback and a stereo playback, as well as an attenuator function which automatically adjusts an attenuation of the level of the FM detection signal Ddet.

Once the level of the S-meter signal Sm decreases due to a deterioration in a reception environment, the high cut control function will automatically adjust a high frequency cut-off frequency to inhibit a high frequency noise component of the FM detection signal Ddet in response to a decreasing amount of the level of the S-meter signal, while the attenuator function will attenuate the level of the FM detection signal Ddet, thereby improving an S/N value.

Further, the channel separation control function performs an automatic switchover from a stereo playback to a monophonic playback, so that even if a speaker or the like is caused to produce a sound in accordance with an audio signal output from the foregoing FM stereo demodulator, it is still possible to reproduce a sound and a music or the like capable of reducing a noise feeling and supply the same to a user.

Disclosure of the Invention

Problem(s) to be Solved by the Invention

However, in the above-described conventional FM receiver, once a reception environment deteriorates due to a multi-pass disturbance and a fading or the like and thus a field intensity changes frequently during a short time period, the attenuator function provided in the ARC unit 6 will fail to follow the level change of the S-meter signal Sm which changes in the same manner as the field intensity in response to the field intensity, rendering it impossible to exhibit an original attenuator function. As a result, it becomes impossible to improve an S/N value, rendering it difficult to reduce a noise feeling of a user.

Namely, as shown in Fig. 1(b), when an S-meter signal Sm has a relatively gentle level change caused by a deterioration in a reception environment, the level of the FM detection signal Dout output from the ARC unit 6 will also decrease along with the level change of the S-meter signal Sm and an improvement of the S/N value will be achieved, as shown in Fig. 1(c).

On the other hand, as shown in Fig. 1(d), when a field intensity frequently changes during a short time period due to a deterioration in a reception environment and when the S-meter signal Sm has a frequent level change during a short time period, the ARC unit 6 will fail to follow such changes, thus undesirably outputting an FM detection signal Dout which can not be controlled and thus causes an unstable level variation, as shown in Fig. 1(e). For this reason, when the FM stereo demodulator demodulates an FM detection signal Dout and causes a speaker to produce a sound, there will be a problem that a stimulant noise will occur.

The present invention has been accomplished in view of the above conventional problem and it is an object of the invention to provide an FM receiver capable of further improving an S/N value or the like irrespective of any changes in a reception environment.

Means for Solving the Problem(s)

The object underlying the invention is solved by an FM receiver, comprising: an arctangent detector which generates an FM detection signal by sampling an intermediate frequency signal, by performing an orthogonal transformation of the sampled intermediate frequency signal to generate two signals S and C having a phase difference and by deriving the FM detection signal from the computation of arctan (S/C), wherein the intermediate frequency signal is generated from a reception signal by virtue of a frequency conversion;

variable attenuation means for changing an attenuation factor to adjust a level of a further FM detection signal to be output, with respect to the FM detection signal received from the arctangent detector, in response to a deterioration in a reception environment, the variable attenuation means receiving and attenuating the FM detection signal and generating thereby the further FM detection signal having its level automatically adjusted in accordance with the attenuation factor;

and automatic reception means receiving the further FM detection signal and generating an output FM detection signal, the automatic reception means having an automatic reception function comprising a high cut control function which automatically inhibits a high frequency component of the further FM detection signal received by the automatic reception means in response to a level change of a signal indicating the field intensity of the intermediate frequency signal to improve the S/N value of the FM detection signal and having an attenuator function of changing a further attenuation factor in response to a deterioration in the reception environment, and automatically adjusting the level of the further FM detection signal received by the automatic reception means in accordance with the further attenuation factor, the output FM detection signal resulting from the processing by the high cut control function and the attenuator function, wherein the variable attenuation means change the attenuation factor at a higher speed than the attenuator function of the automatic reception means.

In one specific embodiment of the FM receiver according to the invention, the variable attenuation means adjust the attenuation factor in response to a change of the S-meter signal indicative of an electric field intensity detected from the intermediate frequency signal.

In another specific embodiment of the FM receiver according to the present invention, the variable attenuation means adjust the attenuation factor in response to a change of the noise component contained in the intermediate frequency signal.

According to a further development of the FM receiver according to the invention, the variable attenuation means include delay means for adjusting the attenuation factor in accordance with a time necessary for the arctangent detector to perform a detection processing.

Brief Description of the Drawings

Fig. 1     provides a diagram and graphs showing the construction and the function of a conventional FM receiver.
Fig. 2     is a block diagram showing the construction of an FM receiver formed according to one aspect of the present invention.
Fig. 3     provides waveform charts showing effects of the FM receiver as shown in Fig. 2.
Fig. 4     is a block diagram showing the construction of an FM receiver formed according to one embodiment of the present invention.
Fig. 5     is a block diagram showing the construction of an FM receiver formed according to another embodiment of the present invention.

Best Mode for Carrying Out the Invention

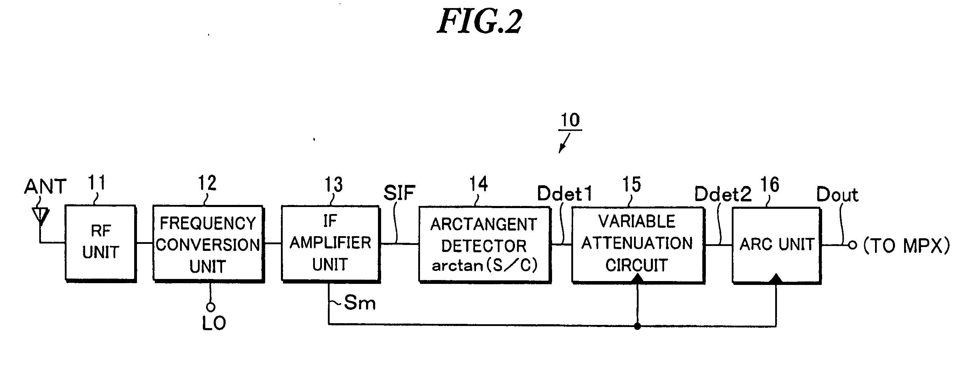

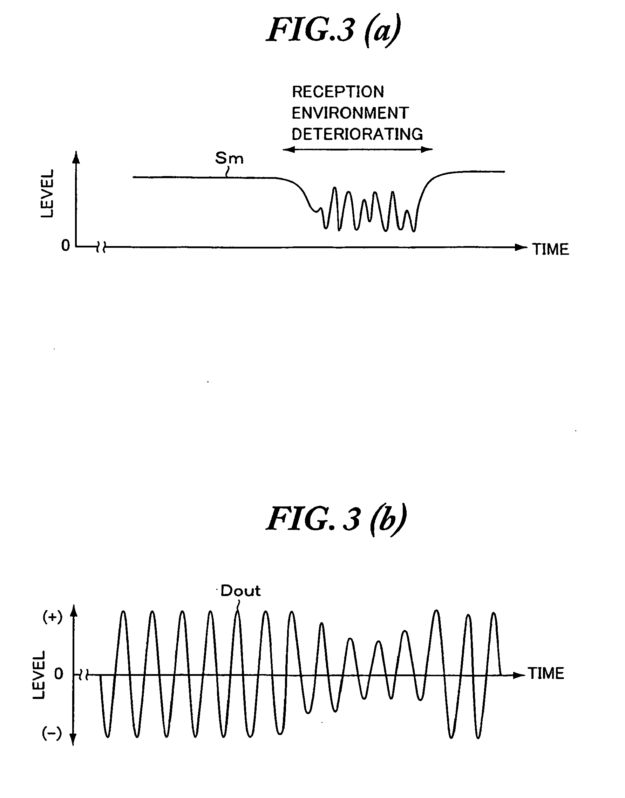

A preferred embodiment of the present invention will be described with reference to Fig. 2 and Fig. 3. Fig. 2 is a block diagram showing the construction of an FM receiver formed according to one aspect of the present invention. Fig. 3 provides waveform charts showing an operation of the FM receiver.

As shown in Fig. 2, the FM receiver 10 comprises: an RF unit 11 connected with a reception antenna ANT which receives an arrival electric wave (broadcast wave); a frequency conversion unit 12; an IF amplifier unit 13; an arctangent detector 14; a variable attenuation circuit 15 serving as variable attenuation means; and an ARC unit 16 forming automatic reception means.

Here, the RF unit 11, the frequency conversion unit 12, the IF amplifier unit 13, the arctangent detector 14, and the ARC unit 16 have the same constructions as a conventional FM receiver. The variable attenuation circuit 15 is provided between the arctangent detector 14 and the ARC unit 16. In this way, the FM receiver 10 can have a feature not existing in a conventional FM receiver.

Namely, when the reception antenna ANT receives a broadcast wave, the RF unit 11 will output an amplified high frequency reception signal, while the frequency conversion unit 12 will mix together a received signal and a local oscillation signal LO having a turning frequency, thereby generating an intermediate frequency signal.

The IF-amplifier unit 13 applies a band limitation to the intermediate frequency signal generated in the frequency conversion unit 12, thereby outputting a band-limited intermediate frequency signal SIF having a baseband frequency. Further, the IF amplifier unit 13 detects a level change of the band-limited intermediate frequency signal SIF, thereby generating and thus outputting a signal Sm (namely, an S-meter signal) indicating a field intensity.

The arctangent detector 14 applies an arctangent detection based on a digital signal processing to the band-limited intermediate frequency signal SIF, thereby outputting an FM detection signal Ddet1. Namely, in order to effect an FM detection based on the digital signal processing, the arctangent detector 14 samples and receives the band-limited intermediate frequency signal SIF using a predetermined sampling frequency, performs an orthogonal transformation to generate two signals S and C having a phase difference, performs a computation processing represented by the foregoing equation (1) to detect a frequency change of the band-limited intermediate frequency signal SIF as a phase change $\omega t$, thereby generating and thus outputting the FM detection signal Ddet1, i.e., a demodulation signal whose level changes in response to a detected phase change.

The ARC unit 16 includes: a high cut control function capable of improving an S/N value by automatically controlling a high frequency component of an FM detection signal Ddet2 output from the below-mentioned variable attenuation circuit 15 in response to a level change of an S-meter signal Sm; a channel separation control function capable of performing an automatic switchover between a monophonic playback and a stereo playback in response to a level change of S-meter signal Sm; and an attenuator function capable of improving an S/N value by automatically adjusting an attenuation of the level of FM detection signal Ddet2 in response to a level change of an S-meter signal Sm. The FM detection signal Dout processed by the high cut control function, the channel separation control function and the attenuator function is supplied to an FM stereo demodulator (MPX) or the like.

The variable attenuation circuit 15 is formed of a variable amplifier or the like which variably adjusts an attenuation factor at a high speed. If the level of an S-meter signal Sm output from the IF amplifier unit 13 becomes lower than a predetermined value, the variable attenuation circuit 15 will change the attenuation factor at a high speed in response to a decreasing amount of the level of the S-meter signal Sm which is becoming lower than a predetermined value, attenuate the level of the FM detection signal Ddet1, and output the attenuated FM detection signal Ddet2.

Namely, the variable attenuation circuit 15 is formed of a variable amplifier or the like which follows a level change of an S-meter signal Sm, and changes an attenuation factor at a higher speed than an attenuator function provided in the ARC unit 16. Then, as shown in the following equations (2-a) and (2-b), when a level value LSm of an S-meter signal Sm becomes equal to or larger than the above-mentioned predetermined value THDa, a reception environment will be judged as being acceptable, and an attenuation factor Gv will be set at 0 (db).

On the other hand, when a level value LSm of the S-meter signal Sm becomes lower than the above-mentioned predetermined value THDa, the variable attenuation circuit 15 will follow the level change of the S-meter signal Sm and increase (in other words, reduce an amplification factor from 0 (dB)) the attenuation factor Gv from 0 (dB) by an amount proportional to an absolute value

| THDa - LSm | of a difference between the level value LSm and the predetermined value THDa, thereby attenuating the level of the FM detection signal Ddet1 and supplying the attenuated FM detection signal Ddet2 to the ARC unit 16.

$$\text{When THDa} \leq \text{LSm,} \quad Gv = 0 \text{ (db)} \quad \quad \dots (2\text{-a)},$$

$$\text{when LSm} < \text{THDa,} \quad Gv = -20 \times \log_{10} |\text{THDa - LSm}| \quad \dots (2\text{-b)}.$$

According to the FM receiver 10 of this aspect of the invention having the above-described constitution, the variable attenuation circuit 15 follows the level change of the S-meter signal Sm to change the attenuation factor Gv, thereby automatically adjusting the level of the FM detection signal Ddet1 FM-detected in the arctangent detector 14. In this way, even if a reception environment changes frequently due to a multi-pass disturbance, a Doppler shift and a fading or the like, it is still possible to generate an FM detection signal Ddet2 capable of improving an S/N value and supply the same to the ARC unit 16.

Further, even if the level of the S-meter signal Sm changes frequently in response to a frequent change in a reception environment caused due to a multi-pass disturbance, a Doppler shift and a fading or the like, and even if the attenuator function provided in the ARC unit 16 does not follow the foregoing change, the variable attenuation circuit 15 provided on the input-stage side of the ARC unit 16 will still generate in advance an FM detection signal Ddet2 capable of improving an S/N value and supply the same to the ARC unit 16. Therefore, it is possible to compensate for the function of the ARC unit 16 and cause the ARC unit 16 to output an FM detection signal Dout having an excellent S/N ratio.

Fig. 3(a) is a waveform chart showing a condition in which S-meter signal Sm changes frequently in the same manner as shown in Fig. 1(d). Fig. 3(b) is another waveform chart showing a level change of an FM detection signal Dout output from the ARC unit 6 as an analog signal change, serving as a waveform chart corresponding to Fig. 1(e).

As can be clearly seen from Figs. 3(a) and 3(b), the variable attenuation circuit 15 automatically adjusts an attenuation factor Gv in response to S-meter signal Sm whose level frequently changes, thereby generating in advance an FM detection signal Ddet2 capable of improving an S/N value and supplying the same to the ARC unit 16.

As a result, it was experimentally confirmed that FM detection signal Dout output from the ARC unit 16 was adjusted in its attenuation factor Gv in response to a level change of the S-meter signal Sm, thereby forming a signal having an improved S/N value. Then, if FM detection signal Dout is supplied to the FM stereo demodulator (MPX) and causes a speaker or the like to produce a sound in accordance with an audio signal demodulated, it becomes possible to reproduce a sound or music capable of reducing a noise feeling and supply the same to a user.

In the FM receiver 10 of this aspect of the invention described above, the variable attenuation circuit 15 variably adjusts the attenuation factor Gv in response to a change in S-meter signal Sm generated in the IF amplifier unit 13. However, it is also possible to provide a noise detecting circuit for detecting a noise component contained in a band-limited intermediate frequency signal SIF, and allow the variable attenuation circuit 15 to automatically adjust the attenuation factor Gv in response to a level change with respect to a time of a noise component detected in the foregoing noise detecting circuit.

Namely, as shown in the following equations (3-a) and (3-b), when the level value LSn of a noise component detected by the above-mentioned noise detecting circuit is equal to or lower than the predetermined value THDb, once a reception environment is judged to be acceptable, the variable attenuation circuit 15 will set an attenuation factor Gv at 0 (db).

On the other hand, when the level value LSn of a noise component is larger than the predetermined value THDb, the variable attenuation circuit 15 will follow the level change of the noise component and increase (in other words, reduce an amplification factor from 0 (dB)) the attenuation factor Gv from 0 (dB) by an amount proportional to an absolute value |THDb - LSn| of a difference between the level value LSn and the predetermined value THDb, thereby attenuating the level of the FM detection signal Ddet1 and supplying the attenuated FM detection signal Ddet2 to the ARC unit 16.

$$\text{When THDb} < \text{LSn,} \qquad Gv = -20 \times \log_{10} |\text{THDb - LSn}| \qquad \text{... (3-a),}$$

$$\text{when LSn} \leq \text{THDb,} \qquad Gv = 0 \text{ (db)} \qquad \text{... (3-b).}$$

Embodiment 1

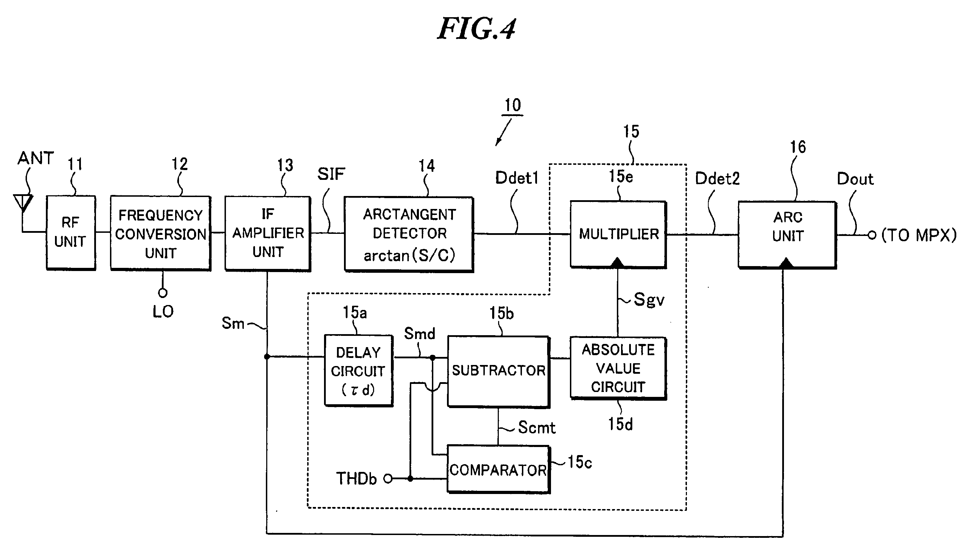

Next, description will be given to an FM receiver according to a detailed embodiment, with reference to Fig. 4. Fig. 4 is a block diagram showing the construction of the FM receiver of the present embodiment, while the elements which are the same as or corresponding to those in Fig. 2 are represented by the same reference numerals.

As shown in Fig. 4, similar to the FM receiver shown in Fig. 2, the FM receiver 10 of the present embodiment comprises: an RF unit 11 connected with a reception antenna ANT; a frequency conversion unit 12; an IF amplifier unit 13; an arctangent detector 14; a variable attenuation circuit 15; and an ARC unit 16.

Here, the variable attenuation circuit 15 is comprised of a delay circuit 15a, a subtractor 15b, a comparator 15c, an absolute value circuit 15d, and a multiplier 15e.

The delay circuit 15a delays the S-meter signal Sm output from the IF amplifier unit 13 by a predetermined delay time τd. Namely, a delay time τd of the delay circuit 15a is set in a manner such that a first processing time T1 and a second processing time T2 become equal to each other. Here, the first processing time T1 lasts from a time point at which the IF amplifier unit 13 outputs a band-limited intermediate frequency signal SIF to another time point at which the arctangent detector circuit 14 generates an FM detection signal Ddet1 by virtue of an arctangent detection and supplies the same to the multiplier 15e.

The second processing time T2 lasts from a time point at which the IF amplifier unit 13 generates and outputs an S-meter signal Sm to a time point at which a gain adjustment signal Sgv is supplied to the multiplier 15e through the delay circuit 15a, the subtractor 15b, and the absolute value circuit 15d.

The subtractor 15b calculates a difference (THDa - LSm) between the level value LSm of the S-meter signal Smd delayed by the delay circuit 15a on one hand and the predetermined value THDa on the other, and supplies the same to the absolute value circuit 15d.

The comparator 15c compares the level value LSm of the S-meter signal Smd with the predetermined value THDa. When the level value LSm is equal to the predetermined value THDa, or when the level value LSm is larger than the predetermined value THDa, the subtractor 15b will be controlled by virtue of switchover control signal Scmt, thereby setting the above difference (THDa - LSm) at a value 1.

On the other hand, when the level value LSm is smaller than the predetermined value THDa, the subtractor 15b will be controlled by virtue of the switchover control signal Scmt, thereby outputting the above difference (THDa - LSm) without being processed to any extent.

In this way, so long as the level value LSm of the S-meter signal Smd has been lower than the predetermined value THDa due to a deteriorated reception environment, it is possible for the comparator 15c to adjust an attenuation in the level of the FM detection signal Ddet1 output from the arctangent detector 14.

The absolute value circuit 15d computes an absolute value |THDa - LSm| of the above difference (THDa - LSm) output from the subtractor 15b and performs a computation represented by Gv = -20 × logic | THDa - LSm |, as shown in the above equation (2-b), thereby calculating an attenuation factor Gv expressed in decibel, and supplying to the multiplier 15e an attenuation factor control signal Sgv indicating an attenuation factor Gv which is a result of the foregoing computation.

Namely, when the above difference (THDa - LSm) output from the subtractor 15b is supplied as a value 1 under the control of the comparator 15c, the absolute value circuit 15d will supply to the multiplier 15e an attenuation factor control signal Sgv having its attenuation factor Gv at 0 (dB).

On the other hand, when the value of the above difference (THDa - LSm) output from the subtractor 15b is supplied without being processed to any extent, an attenuation factor Gv expressed in decibel will be computed from the absolute value | THDa - LSm |, thereby supplying to the multiplier 15e an attenuation factor control signal Sgv indicating an attenuation factor Gv.

The multiplier 15e multiplies the FM detection signal Ddet1 output from the arctangent detector 14 by an attenuation factor Gv specified by the attenuation factor control signal Sgv, so as to generate an FM detection signal Ddet2 having attenuated the level of the FM detection signal Ddet1 and supply the same to the ARC unit 16.

According to the FM receiver 10 of the present embodiment described above, the variable attenuation circuit 15 follows a level change of S-meter signal Sm and changes the attenuation factor Gv, thereby automatically adjusting the level of the FM detection signal Ddet1 FM-detected in the arctangent detector 14. Therefore, even if a reception environment appears to change frequently due to a multi-pass disturbance, a Doppler shift, a fading or the like, it is still possible to generate an FM detection signal Ddet2 capable of improving an S/N value and supply the same to the ARC unit 16.

Furthermore, even if the level of the S-meter signal Sm changes frequently in response to a frequent change in a reception environment caused due to a multi-pass disturbance, a Doppler shift, a fading or the like, and even if the attenuator function provided in the ARC unit 16 does not follow the change, the variable attenuation circuit 15 provided on the input-stage side of the ARC unit 16 will generate in advance an FM detection signal Ddet2 capable of improving an S/N value and supply the same to the ARC unit 16. Therefore, it is possible to compensate for the function of the ARC unit 16, thereby allowing the ARC unit 16 to output an FM detection signal Dout having an excellent S/N value.

Furthermore, with respect to the FM detection signal Ddet1 output from the arctangent detector 14, provision of the delay circuit 15a allows the multiplier 15e to automatically adjust an attenuation factor Gv in accordance with a timing at which a reception environment deteriorates.

Embodiment 2

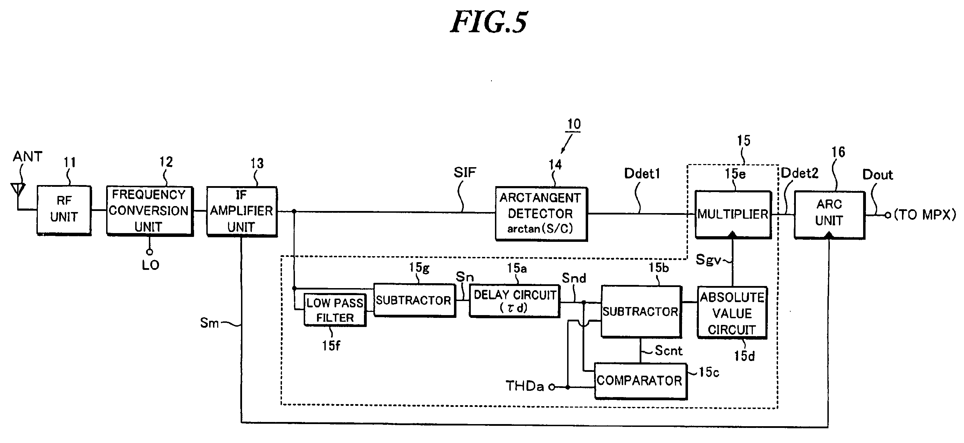

Next, description will be given to explain a further embodiment with reference to Fig. 5. Here, Fig. 5 is a block diagram showing the construction of an FM receiver according to this embodiment, while the elements which are the same as or corresponding to those in Fig. 4 are represented by the same reference numerals.

As shown in Fig. 5, the FM receiver 10 of the present embodiment is similar to the FM receiver of the embodiment shown in Fig. 4, comprising: an RF unit 11 connected with a reception antenna ANT, a frequency conversion unit 12, an IF amplifier unit 13, an arctangent detector 14, a variable attenuation circuit 15, and an ARC unit 16.

Here, the variable attenuation circuit 15 comprises not only a delay circuit 15a, a subtractor 15b, a comparator 15c, an absolute value circuit 15d, and a multiplier 15e, but also a low pass filter 15f, as well as a subtractor 15g.

The low pass filter 15f is formed of a low pass type filter whose high frequency cut-off frequency is a predetermined frequency which is higher than the highest frequency (an upper side maximum frequency transition) of the band-limited intermediate frequency signal SIF outputted from the IF amplifier unit 13, thereby making it possible to pass an envelope component of the band-limited intermediate frequency signal SIF and supplying the same to the subtractor 15g.

The subtractor 15g operates to subtract an envelope component of the band-limited intermediate frequency signal SIF, thereby extracting a noise component Sn generated in response to a change in a reception environment and supplying the same to the delay circuit 15a.

The delay circuit 15a delays the noise component Sn inputted from the subtractor 15g by a predetermined delay time $\tau d$, and supplies the same to the subtractor 15b and the comparator 15c. Namely, the delay time $\tau d$ of the delay circuit 15a is set in a manner such that a first processing time T1 and a second processing time T2 become equal to each other. Here, the first processing time T1 lasts from a time point at which the IF amplifier unit 13 outputs a band-limited intermediate frequency signal SIF to another time point at which the arctangent detector circuit 14 generates an FM detection signal Ddet1 by virtue of an arctangent detection and supplies the same to the multiplier 15e. The second processing time T2 lasts from a time point at which the band-limited intermediate frequent signal SIF is inputted to the low pass filter 15f to a time point at which a gain adjustment signal Sgv is supplied to the multiplier 15e through the low pass filter 15f, the subtractor 15g, the delay circuit 15a, the subtractor 15b, and the absolute value circuit 15d.

The subtractor 15b calculates a difference (THDb - LSn) between the level value LSn of the noise component Snd delayed by the delay circuit 15a and the predetermined value THDb, and supplies the same to the absolute value circuit 15d.

The comparator 15c compares the level value LSn of a noise component Snd with a predetermined value THDb. When the level value LSn is equal to the predetermined value THDb, or when the level value LSn is smaller than the predetermined value THDb, the subtractor 15b will be controlled by a switchover control signal Scnt so as to set the above difference (THDb - LSn) at a value 1 and output the same. On the other hand, when the level value LSn is larger than the predetermined value THDn, the subtractor 15b will be controlled by a switchover control signal Scnt, thereby outputting the above difference (THDb - LSn) without being processed to any extent.

In this way, as long as the level value LSn of a noise component Snd has become larger than the predetermined value THDb due to a deterioration in a reception environment, the comparator 15c can automatically adjust the level of the FM detection signal Ddet1 outputted from the arctangent detector 14.

The absolute value circuit 15d calculates an absolute value | THDb - LSn of the foregoing difference (THDb - LSn) output from the subtractor 15b, and performs a computation represented by $Gv = -20 \times \log_{10} | THDb - LSn |$, as shown in the above equation (3-a), thereby computing an attenuation factor Gv expressed in decibel, and supplying to the multiplier 15e an attenuation factor control signal Sgv indicating an attenuation factor Gv which is a result of the foregoing computation.

Namely, when the above-mentioned difference (THDb - LSn) output from the subtractor 15b is supplied as a value 1 under the control of the comparator 15c, the absolute value circuit 15d will supply to the multiplier 15e an attenuation factor control signal Sgv which sets an attenuation factor Gv to 0 (dB). On the other hand, when the value of the difference(THDb - LSn) is supplied without being processed to any extent, an attenuation factor Gv expressed in decibel will be calculated from the absolute value | THDb - LSn |, thereby supplying to the multiplier 15e an attenuation factor control signal Sgv indicating an attenuation factor Gv.

The multiplier 15e carries out a multiplication which multiplies an FM detection signal Ddet1 output from the arctangent detector 14 by an attenuation factor Gv specified by the attenuation factor control signal Sgv, thereby generating an FM detection signal Ddet2 having attenuated the level of FM detection signal Ddet1, and supplying the same to the ARC unit 16.

According to the FM receiver 10 of the present embodiment having the above-described construction, extracting a noise component Sn contained in the band-limited intermediate frequency signal SIF makes it possible to detect a change in a reception environment caused due to a multi-pass disturbance, a Doppler shift, a fading or the like, and generate a gain control signal sgv capable of automatically adjusting the multiplier 15e in accordance with the detected noise component Sn. In this way, it is possible to improve an S/N value in response to a deterioration of a reception environment.

Furthermore, similar to the above-described embodiment 1, when the level of an S-meter signal Sm changes frequently in response to a frequent change in a reception environment caused due to a multi-pass disturbance, a Doppler shift, a fading or the like, and when an attenuator function provided in the ARC unit 16 does not follow the foregoing change, the variable attenuation circuit 15 provided on the input-stage side of the ARC unit 16 will generate an FM detection signal Ddet2 capable of improving an S/N value in advance and supply the same to the ARC unit 16. In this way, it is possible to compensate for the function of the ARC unit 16 and allow the ARC unit 16 to output an FM detection signal Dout having an excellent S/N value.

Furthermore, provision of the delay circuit 15a makes it possible for the multiplier 15e to automatically adjust the attenuation factor Gv in accordance with a timing at which a reception environment deteriorates, with respect to an FM detection signal Ddet1 output from the arctangent detector 14. Therefore, it is possible to supply an FM detection signal Ddet2 having an acceptable S/N value to the ARC unit 16.

**Claims**

1. An FM receiver, comprising:

   - an arctangent detector (14) which generates an FM detection signal (Ddet1) by sampling an intermediate frequency signal (SIF), by performing an orthogonal transformation of the sampled intermediate frequency signal (SIF) to generate two signals S and C having a phase difference and by deriving the FM detection signal (Ddet1) from the computation of arctan (S/C), wherein the intermediate frequency signal (SIF) is generated from a reception signal by virtue of a frequency conversion;
   - variable attenuation means (15) for changing an attenuation factor to adjust a level of a further FM detection signal (Ddet2) to be output, with respect to the FM detection signal (Ddet1) received from the arctangent detector (14), in response to a deterioration in a reception environment, the variable attenuation means (15) receiving and attenuating the FM detection signal (Ddet1) and generating thereby the further FM detection signal (Ddet2) having its level automatically adjusted in accordance with the attenuation factor; and
   - automatic reception means (16) receiving the further FM detection signal (Ddet2) and generating an output FM detection signal (Dout), the automatic reception means (16) having an automatic reception function comprising a high cut control function which automatically inhibits a high frequency component of the further FM detection signal (Ddet2) received by the automatic reception means (16) in response to a level change of a signal indicating the field intensity of the intermediate frequency signal to improve the S/N value of the FM detection signal and having an attenuator function of changing a further attenuation factor in response to a deterioration in the reception environment, and automatically adjusting the level of the further FM detection signal (Ddet2) received by the automatic reception means (16) in accordance with the further attenuation factor, the output FM detection signal (Dout) resulting from the processing by the high cut control function and the attenuator function,
   - wherein the variable attenuation means (15) change the attenuation factor at a higher speed than the attenuator function of the automatic reception means (16).

2. The FM receiver according to claim 1,
   wherein the variable attenuation means (15) adjust the attenuation factor in response to a change of the S-meter signal indicative of an electric field intensity detected from the intermediate frequency signal.

3. The FM receiver according to claim 1,
   wherein the variable attenuation means (15) adjust the attenuation factor in response to a change of the noise component contained in the intermediate frequency signal.

**4.** The FM receiver according to any of claims 1 to 3,
wherein the variable attenuation means (15) include delay means (15a) for adjusting the attenuation factor in accordance with a time necessary for the arctangent detector (14) to perform a detection processing.

**Patentansprüche**

**1.** Frequenzmodulationsempfänger, der folgendes aufweist:

- einen Arkustangens-Demodulator (14), welcher ein FM-Demodulationssignal (Ddet1) erzeugt, und zwar durch Abtasten eines Zwischenfrequenzsignals (SIF), durch Ausführen einer Orthogonaltransformation des abgetasteten Zwischenfrequenzsignals (SIF) zum Generieren zweier Signale S und C, die eine Phasendifferenz haben, und durch Herleiten des FM-Demodulationssignals (Ddet1) aus der Berechnung des Arkustangens (S/C), wobei das Zwischenfrequenzsignal (SIF) aus einem Empfangssignal mittels einerFrequenzumsetzung erzeugt wird;
- variable Dämpfungseinrichtungen (15) zum Verändern eines Dämpfungsfaktors, um einen Pegel eines weiteren auszugebenden FM-Demodulationssignals (Ddet2), bezogen auf das von dem Arkustangens-Demodulator empfangene FM-Demodulationssignal (Ddet1), unter Berücksichtigung einer Verschlechterung in einer Empfangsumgebung anzupassen, wobei die variablen Dämpfungseinrichtungen (15) das FM-Demodulationssignal (Ddet1) empfangen und dämpfen und **dadurch** das weitere FM-Demodulationssignal (Ddet2) erzeugen, dessen Pegel automatisch gemäß dem Dämpfungsfaktor angepasst wird; und
- automatische Empfangseinrichtungen (16), welche das weitere FM-Demodulationssignal (Ddet2) empfangen und ein FM-Demodulationsausgabesignal (Dout) erzeugen, wobei die automatischen Empfangseinrichtungen (16) eine automatische Empfangsfunktion haben, die eine Tiefpass-Steuerungsfunktion aufweist, welche automatisch einen Hochfrequenzanteil des weiteren FM-Demodulationssignals (Ddet2), das von den automatischen Empfangseinrichtungen (16) empfangen worden ist, in Abhängigkeit von einer Pegeländerung eines die Feldstärke des Zwischenfrequenzsignals angebenden Signals sperrt, um den Wert des Rauschabstandes des FM-Demodulationssignals zu verbessern, und wobei die automatischen Empfangseinrichtungen (16) eine Dämpfungsfunktion zum Verändern eines weiteren Dämpfungsfaktors unter Berücksichtigung einer Verschlechterung in der Empfangsumgebung haben, und wobei die automatischen Empfangseinrichtungen (16) automatisch den Pegel des weiteren FM-Demodulationssignals (Ddet2), das von den automatischen Empfangseinrichtungen (16) empfangen worden ist, gemäß dem weiteren Dämpfungsfaktor anpassen, wobei sich das FM-Demodulationsausgabesignal (Dout) aus der Verarbeitung durch die Tiefpass-Steuerungsfunktion und die Dämpfungsfunktion ergibt,
- wobei die variablen Dämpfungseinrichtungen (15) den Dämpfungsfaktor mit einer höheren Geschwindigkeit als die Dämpfungsfunktion der automatischen Empfangseinrichtungen (16) verändern.

**2.** Frequenzmodulationsempfänger nach Anspruch 1,
wobei die variablen Dämpfungseinrichtungen (15) den Dämpfungsfaktor in Abhängigkeit von einer Veränderung des S-Meter-Signals anpassen, das eine aus dem Zwischenfrequenzsignal ermittelte elektrische Feldstärke angibt.

**3.** Frequenzmodulationsempfänger nach Anspruch 1,
wobei die variablen Dämpfungseinrichtungen (15) den Dämpfungsfaktor in Abhängigkeit von einer Veränderung des Rauschanteils anpassen, der im Zwischenfrequenzsignal enthalten ist.

**4.** Frequenzmodulationsempfänger nach einem der Ansprüche 1 bis 3,
wobei die variablen Dämpfungseinrichtungen (15) Verzögerungseinrichtungen (15a) aufweisen, um den Dämpfungsfaktor in Abhängigkeit von einer Zeit einzustellen, welche der Arkustangens-Demodulator (14) zum Durchführen einer Demodulationsverarbeitung benötigt.

**Revendications**

**1.** Récepteur FM, comprenant:

- un détecteur arctangente (14) qui génère un signal de détection FM (Ddet1) en échantillonnant un signal à fréquence intermédiaire (SIF), en exécutant une transformation orthogonale du signal à fréquence intermédiaire échantillonné (SIF) pour générer deux signaux S et C ayant une différence de phase et en dérivant le signal de détection FM (Ddet1) par le calcul de arctan(S/C), dans lequel le signal à fréquence intermédiaire (SIF) est généré à partir d'un signal de réception en vertu d'une conversion de fréquence;
- des moyens d'atténuation variables (15) pour changer un facteur d'atténuation et ajuster un niveau d'un autre signal de détection FM (Ddet2) à délivrer, par rapport au signal de détection FM (Ddet1) reçu du détecteur arctangente (14), en réponse à une détérioration dans un environnement de réception, les moyens d'atténuation variables (15) recevant et atténuant le signal de détection FM (Ddet1) et générant ainsi l'autre signal de détection FM (Ddet2) dont le niveau est automatiquement ajusté en accord avec le facteur d'atténuation; et
- des moyens de réception automatique (16) recevant l'autre signal de détection FM (Ddet2) et générant un signal de détection FM en sortie (Dout), les moyens de réception automatique (16) ayant une fonction de réception automatique comprenant une fonction de commande de coupure haute qui inhibent automatiquement une composante à haute fréquence de l'autre signal de détection FM (Ddet2) reçu par les moyens de réception automatique (16) en réponse à un changement de niveau d'un signal indiquant l'intensité de champ du signal à fréquence intermédiaire pour améliorer la valeur signal/bruit du signal de détection FM et ayant une fonction d'atténuation consistant à changer un autre facteur d'atténuation en réponse à une détérioration de l'environnement de réception, et ajustant automatiquement le niveau de l'autre signal de détection FM (Ddet2) reçu par les moyens de réception automatique (16) en accord avec l'autre facteur d'atténuation, le signal de détection FM en sortie (Dout) résultant du traitement par la fonction de commande de coupure haute et par la fonction d'atténuation,
- dans lequel les moyens d'atténuation variables (15) changent le facteur d'atténuation à une vitesse plus élevée que la fonction d'atténuation des moyens de réception automatique (16).

**2.** Récepteur FM selon la revendication 1,
dans lequel les moyens d'atténuation variable (15) ajustent le facteur d'atténuation en réponse à un changement du signal S indiquant une intensité du champ électrique détecté à partir du signal à fréquence intermédiaire.

**3.** Récepteur FM selon la revendication 1,
dans lequel les moyens d'atténuation variable (15) ajustent le facteur d'atténuation en réponse à un changement du composant de bruit contenu dans le signal à fréquence intermédiaire.

**4.** Récepteur FM selon l'une quelconque des revendications 1 à 3,
dans lequel les moyens d'atténuation variable (15) incluent des moyens de retard (15a) pour ajuster le facteur d'atténuation en accord avec un temps nécessaire pour que le détecteur arctangente (14) effectue un traitement de détection.

## FIG.1 (a)

## FIG.1 (b)

## FIG.1 (c)

## FIG.1 (d)

## FIG.1 (e)

## FIG.2

ANT

**11** RF UNIT

**12** FREQUENCY CONVERSION UNIT

LO

**13** IF AMPLIFIER UNIT

SIF

**14** ARCTANGENT DETECTOR arctan(S/C)

Ddet1

**15** VARIABLE ATTENUATION CIRCUIT

Ddet2

**16** ARC UNIT

Dout

(TO MPX)

Sm

10

EP 1 811 676 B1

# FIG.3 (a)

# FIG. 3 (b)

## FIG.4

## FIG.5

EP 1 811 676 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0940909 A